# EUROPÄISCHE PATENTSCHRIFT

(11) **EP 2 815 191 B1**
(45) Veröffentlichungstag und Bekanntmachung des Hinweises auf die Patenterteilung: **27.04.2016**
(21) Anmeldenummer: 13702207.5
(22) Anmeldetag: 24.01.2013
(51) Int. Cl.: F24J 2/52

(54) **VORRICHTUNG ZUM ABSTÜTZEN ZUMINDEST EINES SOLARMODULS**
DEVICE FOR SUPPORTING AT LEAST ONE SOLAR PANEL
DISPOSITIF DE SUPPORT POUR AU MOINS UN MODULE SOLAIRE

(30) Priorität: 13.02.2012 DE 202012001369 U; 03.05.2012 DE 202012004333 U
(43) Veröffentlichungstag der Anmeldung: 24.12.2014
(73) Patentinhaber: Ilzhöfer, Werner, 97437 Haßfurt (DE)
(72) Erfinder: Ilzhöfer, Werner, 97437 Haßfurt (DE)
(74) Vertreter: Gassner, Wolfgang
(86) Internationale Anmeldenummer: PCT/EP2013/051375
(87) Internationale Veröffentlichungsnummer: WO 2013/120678

(56) Entgegenhaltungen:
- EP-A2- 2 182 303
- EP-A2- 2 402 679
- WO-A1-02/073703
- WO-A1-2011/054943
- DE-B3-102010 022 556
- DE-U1-202007 006 094
- DE-U1-202007 008 150
- DE-U1-202010 005 563

## Beschreibung

Die Erfindung betrifft eine Vorrichtung zum Abstützen zumindest eines Solarmoduls nach dem Oberbegriff des Anspruchs 1.

Eine solche Vorrichtung ist aus der WO 2011/054943 A1 bekannt. Die Vorrichtung umfasst zwei Stützeinrichtungen. Jede der Stützeinrichtungen weist eine Stützleiste auf, auf deren einer Seite ein erstes Befestigungselement angebracht ist. Das Solarmodul weist einen rechteckigen Rahmen mit zwei einander gegenüberliegenden Streben auf. Zum Aufrichten des Solarmoduls wird die eine Strebe an die ersten Befestigungselemente eingehängt. Anschließend wird eine im Bereich der anderen Strebe vorgesehene schwenkbare Stützwand von einer Transportposition in eine Stützposition ausgeklappt und beispielsweise mittels Schrauben oder Nieten an zweiten Befestigungselementen angebracht, welche ebenfalls auf der Stützleiste befestigt sind. - Zum Aufrichten des bekannten Solarmoduls sind Befestigungselemente sowie ein Schraub- oder Nietwerkzeug erforderlich. Abgesehen davon müssen für jeden Stützwandtyp dazu korrespondierende zweite Befestigungselemente auf der Stützleiste vorgesehen sein. Das erfordert einen relativ hohen Herstellungsaufwand.

Ein weiterer Halter für ein Solarpanel ist aus der WO 02/073703 A bekannt, bei der an der Stützleiste in einem vorgegebenen Abstand vom ersten Befestigungselement schwenkbar zumindest eine Stütze angebracht ist, die an ihrem freien Ende ein zweites Befestigungselement zur Befestigung der der einen Strebe gegenüberliegenden anderen Strebe aufweist. Die Stütze ist nach Art eines U-Profils ausgebildet. Das U-Profil weist einen Profilgrundabschnitt und zwei davon sich in einem Abstand erstreckende, einander gegenüberliegende Schenkel auf, wobei der Abstand größer als eine Breite der Stützleiste ist, so dass das Profil in einem eingeklappten Zustand die Stützleiste teilweise umgreift.

Aufgabe der Erfindung ist es, die Nachteile nach dem Stand der Technik zu beseitigen. Es soll insbesondere eine Vorrichtung angegeben werden, welche ein schnelles, einfaches und sicheres Abstützen von Solarmodulen auf einer im Wesentlichen horizontalen Unterlage, beispielsweise einem Flachdach, ermöglicht. Nach einem weiteren Ziel der Erfindung soll die Vorrichtung universell sein, d. h. das Aufrichten unterschiedlicher am Markt verfügbarer Solarmodule ermöglichen.

Diese Aufgabe wird durch die Merkmale des Anspruchs 1 gelöst. Zweckmäßige Ausgestaltungen der Erfindung ergeben sich aus den Merkmalen der Ansprüche 2 bis 11.

Nach Maßgabe der Erfindung wird vorgeschlagen, dass das zweite Befestigungselement aus sich über den Profilgrundabschnitt erstreckenden Befestigungsabschnitten gebildet ist, welche jeweils einen Schlitz zum Eingriff in die andere Strebe aufweisen, und wobei am freien Ende der Stütze ein vom Profil-grundabschnitt sich erstreckender, in Richtung zum Schlitz hin umgebogener Sicherungsabschnitt vorgesehen ist.

Die Stütze weist im Bereich des zweiten Befestigungselements eine größere Breite auf als bei der Stützleiste. Das macht die Vorrichtung besonders universell. Sie eignet sich insbesondere auch zum Abstützen von Solarmodulen, bei denen im Eckbereich des Rahmens ein Verstärkungselement eingesetzt ist.

Die vorgeschlagene Vorrichtung lässt sich einfach und kostengünstig herstellen. Sie eignet sich zum Aufrichten einer Vielzahl unterschiedlicher ausgestalteter Solarmodule.

Vorteilhafterweise weist jeder Schenkel einen über den Profilgrundabschnitt sich erstreckenden Schwenkbefestigungsabschnitt mit einem ersten Durchbruch auf. Die einander gegenüberliegenden Schwenkbefestigungsabschnitte einer Stütze liegen an den Seitenwänden der Stützleisten an. Durch den ersten Durchbruch ist ein Befestigungselement, beispielsweise ein Niet oder dgl., geführt, welches eine Schwenkbewegung der Stütze um eine durch die ersten Durchbrüche verlaufende Schwenkachse ermöglicht.

Das zweite Befestigungselement ist aus sich über den Profilgrundabschnitt erstreckenden Befestigungsabschnitten gebildet, welche jeweils eine Ausnehmung zum Eingriff in die andere Strebe aufweisen. Die Ausnehmung ist zweckmäßigerweise so ausgestaltet, dass sie die andere Strebe zumindest abschnittsweise umgreift.

Die Streben können aus einem L- oder aus einem weiteren U-Profil gebildet und so angeordnet sein, dass Rahmenschenkel der einander gegenüberliegenden Streben zueinander gewandt sind, wobei die Ausnehmung ein zu den Rahmenschenkel korrespondierender Schlitz ist. D. h. die Ausnehmung ist vorteilhafterweise so ausgestaltet, dass sie beim Verschwenken der Stütze in den nach innen gewandten freien Rahmenschenkel des Rahmens eingreift, wodurch der Rahmen gegen ein Abheben von der Stütze gesichert wird. In diesem Fall wird das Solarmodul also sowohl mit dem ersten Befestigungselement als auch mit dem zweiten Befestigungselement ausschließlich an den freien Rahmenschenkeln der einander gegenüberliegenden Streben befestigt. Das macht die Vorrichtung besonders universell. Es müssen insbesondere keine, beispielsweise auf unterschiedliche Rahmenhöhen ausgelegte, besondere Befestigungselemente vorgesehen werden.

Eine Weite des Schlitzes vergrößert sich zweckmäßigerweise in Richtung zur Schlitzöffnung hin. Ferner ist es zweckmäßig, dass zumindest ein Ufer des Schlitzes einen Radius aufweist. Bei einer entsprechend geeigneten Ausgestaltung des Schlitzes gelingt es, dass die Stütze mit dem Rahmenschenkel des Rahmens verrastet oder klemmend am Rahmenschenkel befestigt werden kann. Das ermöglicht ein besonders schnelles und einfaches Aufrichten des Solarmoduls. Ferner ist am freien Ende der Stütze ein vom Profilgrund sich erstreckender, in Richtung zur Ausnehmung hin umgebogener Sicherungsabschnitt vorgesehen. Bei dem Sicherungsabschnitt handelt es sich z. B. um eine Blechzunge oder -lasche. Durch ein Umbiegen des Sicherungsabschnitts ist es auf einfache Weise möglich, die Stütze am Rahmen zu sichern, d. h. es ist dann nicht mehr möglich, die Stütze in Richtung der Stützleiste zurückzuklappen. Abgesehen davon kann durch den Sicherungsabschnitt der Rahmen bzw. der Rahmenschenkel der anderen Strebe im Schlitz des zweiten Befestigungselements der Stütze fixiert werden.

Vorteilhafterweise ist am freien Ende der Stütze, vorzugsweise am Sicherungsabschnitt, ein zweiter Durchbruch vorgesehen. Der zweite Durchbruch ermöglicht ein Verrasten oder reibschlüssiges Befestigen eines zweiten Sicherungselements. Sofern der zweite Durchbruch am Sicherungsabschnitt vorgesehen ist, kann der Sicherungsabschnitt beispielsweise durch einfaches Einstecken eines Schraubenziehers in eine Sicherungsposition gebogen werden.

Nach einer weiteren Ausgestaltung sind im Profilgrundabschnitt zwei dritte Durchbrüche vorgesehen. Die Stützen zweier nebeneinander angeordneter Stützleisten sind zweckmäßigerweise mit einer Verbindungswand verbunden. Die Verbindungswand weist zweckmäßigerweise zu den dritten Durchbrüchen korrespondierende vierte Durchbrüche zum Durchführen von Befestigungselementen, insbesondere Niete, auf. Bei den vierten Durchbrüchen kann es sich um Bohrungen und/oder Langlöcher handeln. Zweckmäßigerweise sind zu jedem der dritten Durchbrüche mehrere vierte Durchbrüche vorgesehen. Das erleichtert insbesondere bei einem nicht vollständig ebenen Untergrund die Befestigung der Verbindungswand.

Anstelle der dritten und vierten Durchbrüche kann es auch sein, dass beispielsweise am Profilgrundabschnitt der Stützen Blechzungen vorgesehen sind, in welche dazu korrespondierende Blechlaschen oder weitere Schlitze an den Verbindungswänden reibschlüssig einsteckbar sind.

Die Verbindungswand kann einen parallel zu deren Längskanten verlaufenden abgewinkelten Abschnitt aufweisen, welcher von den Stützen im Bereich deren freien Ende weg weist. Der abgewinkelte Abschnitt bildet mit den Stützen vorteilhafterweise einen spitzen Winkel. Infolgedessen ergibt sich zwischen einer oberen Längskante des Solarmoduls und dem abgewinkelten Abschnitt der Verbindungswand ein Spalt. Der Spalt ermöglicht eine Hinterlüftung und damit eine Kühlung der Solarmodule im Sommer.

Zweckmäßigerweise entspricht eine Länge der Verbindungswand etwa einer Länge des Solarmoduls. Die Verbindungswand hat den Zweck, Wind abzuweisen.

Nach einer weiteren Ausgestaltung der Erfindung sind an der der einen Seite abgewandten anderen Seite der Stützleiste, vorzugsweise stranggepresste, Elastomerelemente angebracht. Die Elastomerelemente können ähnlich einem U-Profil ausgestaltet sein und die Stützleiste seitlich teilweise umgreifen. Die Elastomerelemente können an ihrer Befestigungsseite eine langgestreckte Feder aufweisen. In diesem Fall weist die Stützleiste an der anderen Seite zweckmäßigerweise eine Nut zum Befestigen der Feder auf. Bei der Stützleiste kann es sich um ein, vorzugsweise stranggepresstes, Vierkantprofil handeln.

Nachfolgend wird ein Ausführungsbeispiel der Erfindung anhand der Zeichnung näher erläutert. Es zeigen:
- Fig. 1: eine perspektivische Ansicht der Vorrichtung,
- Fig. 2: eine perspektivische Ansicht einer Stützeinrichtung gemäß Fig. 1,
- Fig. 3: eine Seitenansicht einer Stützeinrichtung mit eingeklappter Stütze,
- Fig. 4: die Seitenansicht gemäß Fig. 3 mit teilweise verschwenkter Stütze,
- Fig. 5: die Seitenansicht gemäß Fig. 3 mit vollständiger verschwenkter Stütze und
- Fig. 6: eine Draufsicht auf eine weitere Stütze.

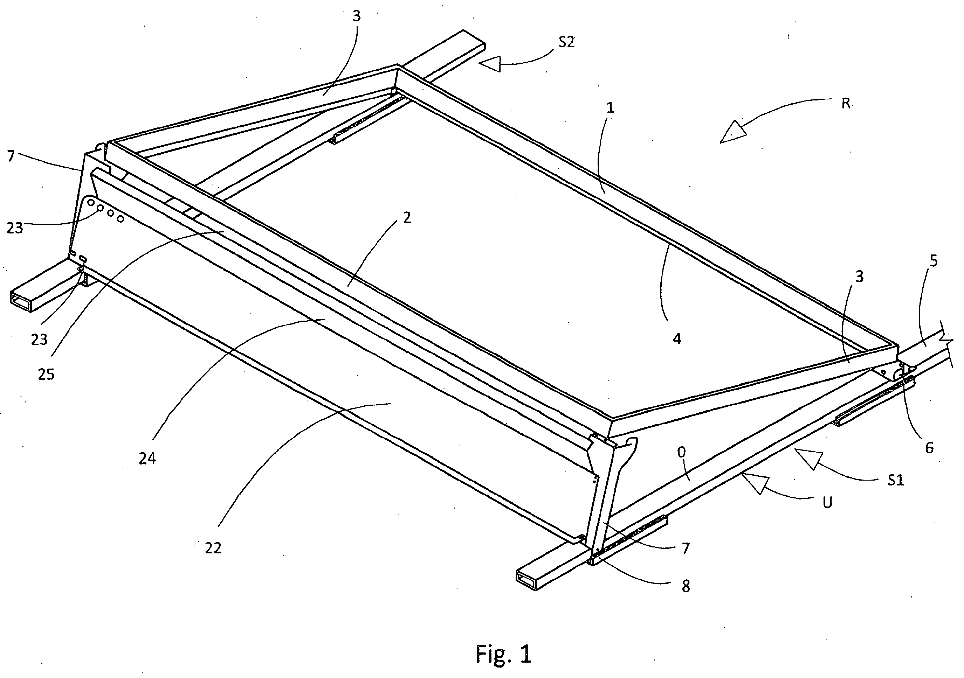

In Fig. 1 weist ein der Übersichtlichkeit halber hier nicht vollständig dargestelltes Solarmodul einen rechteckigen Rahmen R mit einer ersten langen Strebe 1 und einer gegenüberliegenden zweiten langen Strebe 2 sowie einander gegenüberliegenden kurzen Streben 3 auf. Die Streben 1, 2, 3 sind hier jeweils nach Art eines L-Profils ausgebildet, wobei freie Rahmenschenkel 4 der einander gegenüberliegenden Streben 1, 2 und 3 jeweils zueinander gewandt sind.

Mit dem Bezugszeichen S1 und S2 sind Stützeinrichtungen bezeichnet. Jede der Stützeinrichtungen S1, S2 weist eine Stützleiste 5 auf, die beispielsweise aus einem Vierkantrohr gebildet ist. Auf einer oberen Seite O der Stützleiste 5 ist ein ersten Befestigungselement 6 montiert. In einem vorgegebenen Abstand vom ersten Befestigungselement 6 ist eine Stütze 7 schwenkbar an der Stützleiste 5 angebracht. Mit dem Bezugszeichen 8 sind Elastomerelemente bezeichnet, welche an einer Unterseite U der Stützleisten 5 angebracht und beispielsweise mittels eines Klebstoffs gesichert sind.

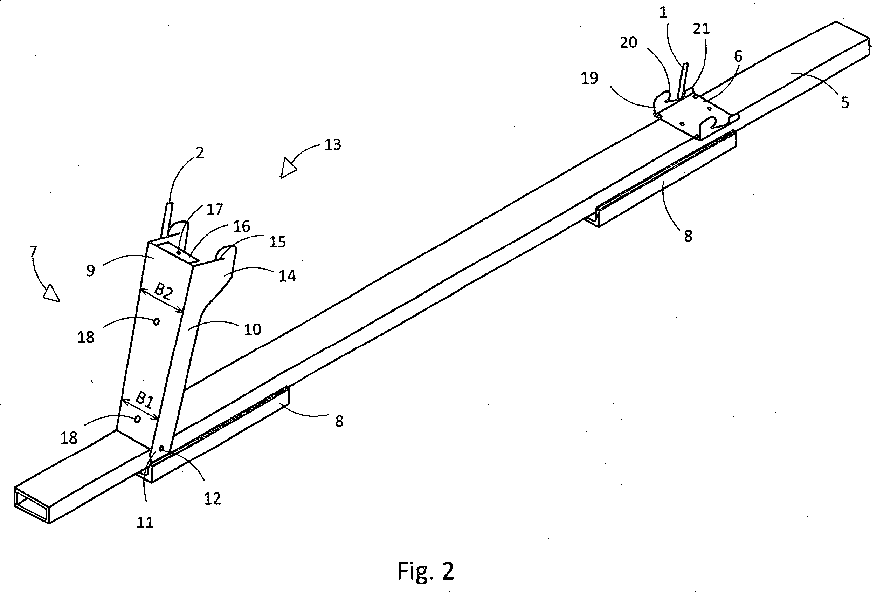

Wie insbesondere aus Fig. 2 hervorgeht, ist die Stütze 7 nach Art eines U-Profils ausgebildet. Sie weist einen Profilgrundabschnitt 9 und zwei davon sich erstreckende einander gegenüberliegende Schenkel 10 auf. Von den Schenkeln 10 erstrecken sich jeweils Schwenkbefestigungsabschnitte 11, welche einen ersten Durchbruch 12 aufweisen, durch die Befestigungsmittel (hier nicht gezeigt) geführt sind, so dass die Stütze 7 schwenkbar an der Stützleiste 5 gehalten ist. Eine erste Breite B1 des Profilgrundabschnitts 9 in der Nähe der Schwenkbefestigungsabschnitte 11 ist kleiner als eine zweite Breite B2 in der Nähe eines freien Endes der Stütze 7. Der Profilgrundabschnitt 9 weist also eine trapezartige Form auf. Ein am freien Ende der Stütze 7 vorgesehenes Befestigungselement 13 umfasst Befestigungsabschnitte 14, welche sich von den Schenkeln 10 erstrecken. Jeder der Befestigungsabschnitte 14 weist einen Schlitz 15 auf, welcher sich zum Profilgrundabschnitt 9 hin öffnet. Am freien Ende des Profilgrundabschnitts 9 ist außerdem ein Sicherungsabschnitt 16 vorgesehen, welcher durch eine um etwa 90° vom Profilgrundabschnitt 9 umgebogene Lasche gebildet ist. Der Sicherungsabschnitt 16 weist einen zweiten Durchbruch 17 auf. Mit dem Bezugszeichen 18 sind dritte Durchbrüche bezeichnet, welche im Profilgrundabschnitt 9 vorgesehen sind.

Das erste Befestigungselement 6 weist ähnlich wie das zweite Befestigungselement 13 weitere Befestigungsabschnitte 19 auf, die jeweils mit einem weiteren Schlitz 20 versehen sind. Das Befestigungselement 6 ist bezüglich der Stütze 7 so auf der Oberseite O der Stützleiste 5 montiert, dass sich der weitere Schlitz 20 bezüglich des Schlitzes 15 in eine entgegengesetzte Richtung öffnet. Gegenüberliegend einer Öffnung des weiteren Schlitzes 20 ist jeweils ein Stützelement 21 vorgesehen. Mit dem Bezugszeichen 1 ist die erste Strebe angedeutet.

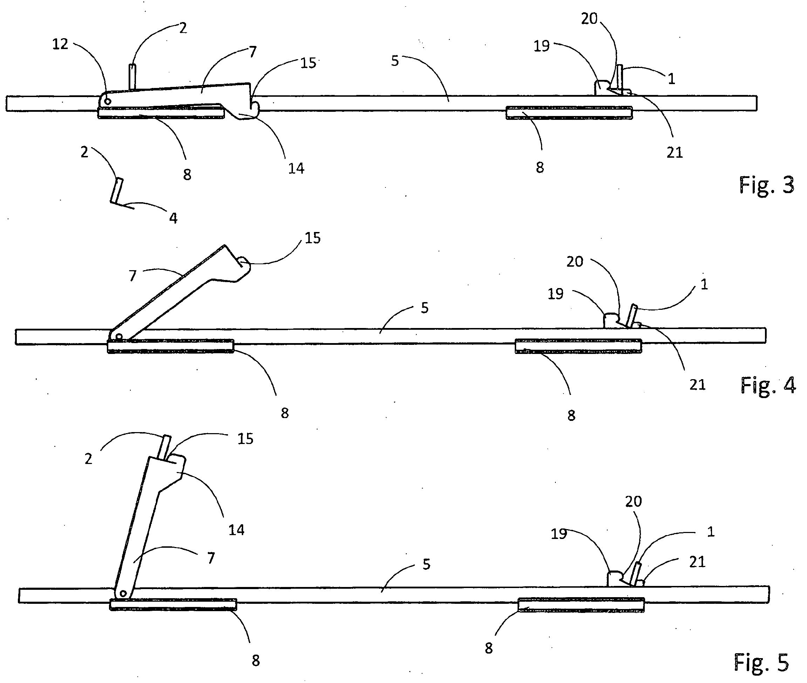

Die Funktion der Vorrichtung wird nunmehr, insbesondere anhand der Fig. 3 bis 5, näher erläutert.

Zum Aufrichten eines Solarmoduls werden zunächst zwei Stützleisten 5 in einem geeigneten Abstand parallel zueinander ausgerichtet, so dass die ersten Befestigungselemente 6 nebeneinander liegen. Die Stützen 7 befinden sich - wie in Fig. 3 gezeigt ist - im eingeklappten Zustand. Anschließend wird der eine Rahmenschenkel 4 der ersten Strebe 1 in den weiteren Schlitz 20 der ersten Befestigungselemente 6 eingesteckt.

Nachfolgend wird die zweite Strebe 2 des Rahmens R angehoben. Dadurch gelangt die erste Strebe 1 in Anlage mit dem Stützelement 21. Infolgedessen ist die erste Strebe 1 gegen ein Verschieben in die Erstreckungsrichtung der Stützleiste 5 gesichert. Das ist in Fig. 4 gezeigt.

Beim weiteren Verschwenken der Stütze 7 greift der Schlitz 15 in den Rahmenschenkel 4 der zweiten Strebe 2 ein. Bei einer geeigneten Ausgestaltung des Schlitzes 15 verrastet das so ausgestaltete zweite Befestigungselement 13 mit der zweiten Strebe 2. Die Verrastung kann durch ein nachfolgendes Hochbiegen der Sicherungslasche gesichert werden.

Schließlich kann an zwei benachbarten Stützen 7 die in Fig. 1 mit dem Bezugszeichen 22 bezeichnete Verbindungswand befestigt werden. Die Verbindungswand 22 weist dazu vierte Durchbrüche 23 auf. Ferner weist die Verbindungswand 22 einen abgewinkelten Abschnitt 24 auf, so dass sich im befestigten Zustand der Verbindungswand 22 zwischen einer Unterkante der zweiten Strebe 2 und der Verbindungswand 22 ein Spalt 25 ausbildet, welcher eine Hinterlüftung des Solarmoduls ermöglicht.

Anstelle des ersten 6 und des zweiten Befestigungselements 13 können auch andersartig ausgestaltete Befestigungselemente, beispielsweise Klemmelemente, Rast- oder Steckelemente vorgesehen sein.

Anstelle des Sicherungsabschnitts 16 kann auch ein in herkömmlicher Weise ausgestaltetes verrastbares Sicherungselement zum Sichern der Stütze 7 im ausgeklappten Zustand verwendet werden. Ein solches Sicherungselement kann beispielsweise in den zweiten Durchbruch 17 eingesteckt oder im zweiten Durchbruch 17 verrastet werden. Es kann sich beispielsweise um ein Kunststoff- oder Elastomerelement handeln.

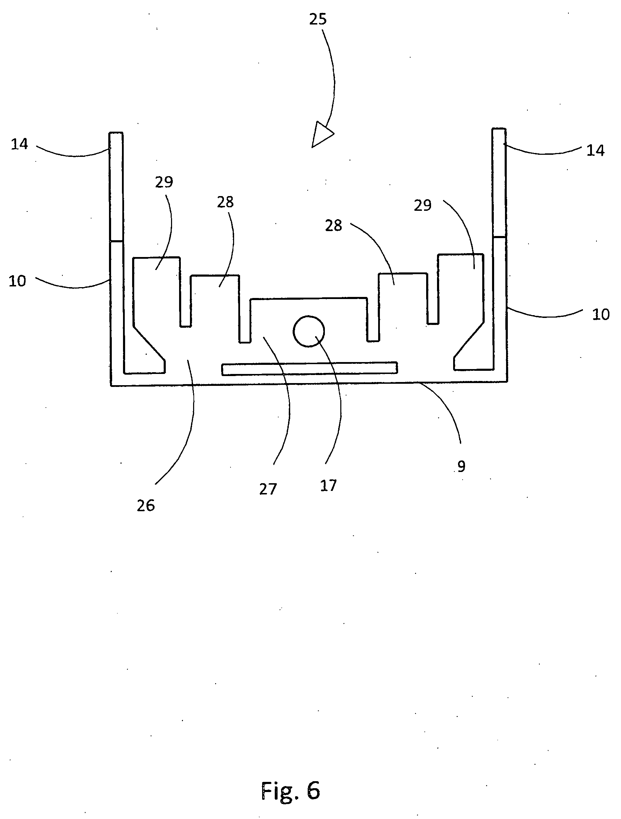

Fig. 6 zeigt eine Draufsicht auf eine weitere Stütze 25. Die weitere Stütze 25 weist einen weiteren Sicherungsabschnitt 26 auf. Der weitere Sicherungsabschnitt 26 wiederum ist im Wesentlichen symmetrisch ausgebildet und weist eine erste Zunge 27 auf, welche mit dem zweiten Durchbruch 17 versehen ist. Beidseits der ersten Zunge 27 sind zweite Zungen 28 und beidseits der zweiten Zungen dritte Zungen 29 vorgesehen. Die erste 27, zweiten 28 und dritten Zungen 29 sind jeweils durch Einschnitte voneinander getrennt. Die erste Zunge 27 erstreckt sich mit einer ersten Tiefe in Richtung des Befestigungsabschnitts 14, die zweiten Zungen 28 erstrecken sich mit einer zweiten Tiefe in Richtung des Befestigungsabschnitts 14 und die dritten Zungen 29 erstrecken sich mit einer dritten Tiefe in Richtung des Befestigungsabschnitts 14. Die erste Tiefe ist kleiner als die zweite Tiefe; die zweite Tiefe ist kleiner als die dritte Tiefe. Mit der vorgeschlagenen Ausgestaltung des weiteren Sicherungsabschnitts 26 ist es möglich, mittels der weiteren Stütze 25 unterschiedlich ausgestaltete zweite Streben zu befestigen. Durch Einstecken eines Werkzeugs in den zweiten Durchbruchs 17 können beispielsweise auch zweite Streben 2 gesichert werden, die sich beispielsweise über die dritten Zungen 29 erstrecken. In diesem Fall können solche Streben durch Hochbiegen der ersten 27 sowie der zweiten Zungen 28 gesichert werden. Die vorgeschlagene weitere Stütze 25 eignet sich also universell zur Befestigung einer Vielzahl von am Markt befindlicher Solarmodule.

Das erste Befestigungselement 6 sowie die Stütze 7 sind vorteilhafterweise aus mittels Laserschneiden hergestellten Blechen gebildet, welche nachfolgend gekantet sind. Sowohl das erste Befestigungselement 6 als auch die Stütze 7 sind zweckmäßigerweise aus einem Stück gefertigt.

Wie insbesondere aus Fig. 1 ersichtlich ist, dienen das erste Befestigungselement 6 sowie das zweite Befestigungselement 13 jeweils der Abstützung zweier benachbarter Solarmodule. Das macht die Vorrichtung besonders effizient. Sie ermöglicht ein Aufständern einer Vielzahl von Solarmodulen mit einem geringen Montage- und Herstellungsaufwand.

Obwohl es in den Figuren nicht gezeigt ist, können auf einer Stützleiste 5 mehrere erste Befestigungselemente 6 sowie mit zweiten Befestigungselementen 13 versehene Stützen 7 abwechselnd montiert sein. D. h. eine Stützeinrichtung S1, S2 kann in diesem Fall zum Abstützen mehrerer Solarmodule hintereinander verwendet werden, was die Effizienz der Vorrichtung weiter verbessert.

### Bezugszeichenliste

- 1: erste Strebe
- 2: zweite Strebe
- 3: kurze Strebe
- 4: Rahmenschenkel
- 5: Stützleiste
- 6: erstes Befestigungselement
- 7: Stütze
- 8: Elastomerelement
- 9: Profilgrundabschnitt
- 10: Schenkel
- 11: Schwenkbefestigungsabschnitt
- 12: erster Durchbruch
- 13: zweites Befestigungselement
- 14: Befestigungsabschnitt
- 15: Schlitz
- 16: Sicherungsabschnitt
- 17: zweiter Durchbruch
- 18: dritter Durchbruch
- 19: weiterer Befestigungsabschnitt
- 20: weiterer Schlitz
- 21: Stützelement
- 22: Verbindungswand
- 23: vierter Durchbruch
- 24: abgewinkelter Abschnitt
- 25: Spalt
- 26: weiterer Sicherungsabschnitt
- 27: erste Zunge
- 28: zweite Zungen
- 29: dritte Zungen
- B1: erste Breite
- B2: zweite Breite
- O: Oberseite
- R: Rahmen
- S1: erste Stützeinrichtung
- S2: zweite Stützeinrichtung
- U: Unterseite

## Patentansprüche

1. Vorrichtung zum Abstützen zumindest eines Solarmoduls, welches einen rechteckigen Rahmen (R) mit zwei einander gegenüberliegenden Streben (1, 2) aufweist, mit zumindest zwei Stützeinrichtungen (S1, S2), wobei jede der Stützeinrichtungen (S1, S2) eine Stützleiste (5) aufweist, an deren einer Seite (O) zumindest ein erstes Befestigungselement (6) zur Befestigung der einen Strebe (1) vorgesehen ist, wobei an der Stützleiste (5) in einem vorgegebenen Abstand vom ersten Befestigungselement (6) schwenkbar zumindest eine Stütze (7) angebracht ist, die an ihrem freien Ende ein zweites Befestigungselement (13) zur Befestigung der der einen Strebe (1) gegenüberliegenden anderen Strebe (2) aufweist, wobei die Stütze (7) nach Art eines U-Profils ausgebildet ist, wobei das U-Profil einen Profilgrundabschnitt (9) und zwei davon sich in einem Abstand (B1, B2) erstreckende, einander gegenüberliegende Schenkel (10) aufweist, und wobei der Abstand (B1, B2) größer als eine Breite der Stützleiste (5) ist, so dass das U-Profil in einem eingeklappten Zustand die Stützleiste (5) teilweise umgreift
**dadurch gekennzeichnet, dass**
das zweite Befestigungselement (13) aus sich über den Profilgrundabschnitt (9) erstreckenden Befestigungsabschnitten (14) gebildet ist, welche jeweils einen Schlitz (15), welcher sich zum Profilgrundabschnitt (9) hin öffnet, zum Eingriff in die andere Strebe (2) aufweisen, und wobei am freien Ende der Stütze (7) ein vom Profilgrundabschnitt (9) sich erstreckender, in Richtung zum Schlitz (15) hin umgebogener Sicherungsabschnitt (16) vorgesehen ist.

2. Vorrichtung nach Anspruch 1, wobei der Profilgrundabschnitt (9) sich in Richtung des freien Endes verbreitert.

3. Vorrichtung nach einem der vorhergehenden Ansprüche, wobei jeder Schenkel (10) einen über den Profilgrundabschnitt (9) sich ersteckenden Schwenkbefestigüngsabschnitt (11) mit einem ersten Durchbruch (12) aufweist.

4. Vorrichtung nach einem der vorhergehenden Ansprüche, wobei eine Weite des Schlitzes (15) sich in Richtung zu einer Schlitzöffnung hin vergrößert.

5. Vorrichtung nach einem der vorhergehenden Ansprüche, wobei am freien Ende der Stütze (7), vorzugsweise am Sicherungsabschnitt (16), ein zweiter Durchbruch (17) vorgesehen ist.

6. Vorrichtung nach einem der vorhergehenden Ansprüche, wobei im Profilgrundabschnitt (9) zwei dritte Durchbrüche (18) vorgesehen sind.

7. Vorrichtung nach einem der vorhergehenden Ansprüche, wobei die Stützen (7) zweier nebeneinander angeordneter Stützleisten (5) mit einer Verbindungswand (22) verbunden sind.

8. Vorrichtung nach Anspruch 7 wobei die Verbindungswand (22) zu den dritten Durchbrüchen (18) korrespondierende vierte Durchbrüche (23) zum Durchführen von Befestigungsmitteln, insbesondere Niete, aufweist.

9. Vorrichtung nach Anspruch 7 oder 8 wobei die Verbindungswand (22) einen parallel zu deren Längskanten verlaufenden abgewinkelten Abschnitt (24) aufweist, welcher von den Stützen (7) im Bereich deren freien Enden weg weist.

10. Vorrichtung nach einem der vorhergehenden Ansprüche, wobei an der der einen Seite (O) abgewandten anderen Seite (U) der Stützleiste (5), vorzugsweise stranggepresste, Elastomerelemente (8) angeracht sind.

11. Vorrichtung nach Anspruch 10 wobei an der anderen Seite (U) eine Nut zum Befestigen einer am Elastomerelement (8) vorgesehenen korrespondierenden Feder vorgesehen ist.

## Claims

1. Device for supporting at least one solar panel, comprising a rectangular frame (R) with two opposite struts (1, 2), with at least two support arrangements (S1, S2), each of which has a support bar (5), one side (O) of which has at least one first fastening element (6) on it for securing one strut (1), the support bar (5) having, pivotally mounted on it at a specific distance from the first fastening element (6), at least one support (7), whose free end has a second fastening element (13) for securing the other one strut (2) lying opposite the one strut (1), support (7) being in the form of a U-profile that has a base section (9) and two legs (10) opposite one another that extend away from the base section at a distance (B1, B2) greater than a width of the support bar (5), so that when folded the U-profile partially surrounds the support bar (5)
**characterized in that**
the second fastening element (13) is formed of fastening sections (14) that extend over the U-profile's base section (9), each of which has a slot (15) opening toward the U-profile's base section (9) to engage into the other one strut (2), and **in that** the free end of the support (7) has a securing section (16) that extends from the U-profile's base section (9) and that is bent back in the direction toward the slot (15).

2. The device described in claim 1, in which the U-profile's base section (9) widens in the direction of its free end.

3. The device described in one of the preceding claims, in which both legs (10) have pivot fastening sections (11) that extend over the U-profile's base section (9) and that have a first opening (12).

4. The device described in one of the preceding claims, in which a width of the slot (15) increases in the direction toward the slot opening.

5. The device described in one of the preceding claims, in which the support (7) has a second opening (17) at its free end, preferably on the securing section (16).

6. The device described in one of the preceding claims, in which the U-profile's base section (9) has two third openings (18).

7. The device described in one of the preceding claims, in which the supports (7) of two support bars (5) arranged next to one another are connected by a connecting wall (22).

8. The device described in claim 7, in which the connection wall (22) has fourth openings (23) corresponding to the third openings (18) to allow fasteners, in particular rivets, to pass through.

9. The device described in one of claims 7 or 8, in which the connection wall (22) has a bent section (24) parallel to its longitudinal edges that points away from the supports (7) in the area of their free ends.

10. The device described in one of the preceding claims, in which the other side (U) of the support bar (5) facing away from the first side (O) has elastomer elements (8) on it, which are preferably extruded.

11. The device described in claim 10, in which the other side (U) has a groove to fasten a corresponding tongue provided on the elastomer element (8).

## Revendications

1. Dispositif de support pour au moins un module solaire qui comporte un cadre rectangulaire (R) pourvu de deux montants opposés (1, 2), d'au moins deux éléments de support (S1, S2), chaque élément de support (S1, S2) comportant une barre de support (5) équipée sur l'une de ses faces (O) d'au moins un premier élément de fixation (6) pour la fixation du premier montant (1), au moins un élément d'appui (7) est monté pivotant sur la barre de support (5) à un écart prédéfini du premier élément de fixation (6), et comporte à son extrémité libre un second élément de fixation (13) destiné à la fixation de l'autre montant (2) opposé au premier montant (1), l'élément d'appui (7) est réalisé sous forme d'un profilé en U, le profilé en U comporte une partie de base du profilé (9) et deux côtés (10) opposés s'étendant à partir de celle-ci à un écart (B1, B2), et l'écart (B1, B2) est supérieur à une largeur de la barre de support (5), de sorte que le profilé en U à l'état rabattu encadre partiellement la barre de support (5)
**caractérisé en ce que**
le second élément de fixation (13) est formé à partir de parties de fixation (14) s'étendant au-dessus de la partie de base du profilé (9), lesdites parties de fixation comportant chacune une rainure (15) s'ouvrant vers la partie de base du profilé (9) pour s'engager dans l'autre montant (2), et **en ce qu'**une partie de sécurité (16) recourbée vers la rainure (15) s'étendant à partir de la partie de base du profilé (9) est prévue sur l'extrémité libre de l'élément d'appui (7).

2. Dispositif selon la revendication 1, en ce que la partie de base du profilé (9) s'élargit vers l'extrémité libre.

3. Dispositif selon l'une des revendications précédentes, en ce que chaque côté (10) comporte une partie de fixation orientable (11) avec un premier orifice (12) s'étendant au-dessus de la partie de base du profilé (9).

4. Dispositif selon l'une des revendications précédentes, en ce qu'une largeur de la rainure (15) s'élargit vers une ouverture de rainure.

5. Dispositif selon l'une des revendications précédentes, en ce qu'un deuxième orifice (17) est prévu à l'extrémité libre de l'élément d'appui (7), de préférence au niveau de la partie de sécurité (16).

6. Dispositif selon l'une des revendications précédentes, en ce que deux troisièmes orifices (18) sont prévus dans la partie de base du profilé (9).

7. Dispositif selon l'une des revendications précédentes, en ce que les éléments d'appui (7) de deux barres de support (5) disposées côte à côte sont reliées à une paroi de liaison (22).

8. Dispositif selon la revendication 7, en ce que la paroi de liaison (22) comporte des quatrièmes orifices (23) correspondant aux troisièmes orifices (18) pour introduire des moyens de fixation, en particulier des rivets.

9. Dispositif selon la revendication 7 ou 8, en ce que la paroi de liaison (22) comporte une partie coudée (24) parallèle à ses arêtes longitudinales, ladite partie coudée étant dans l'autre direction des éléments d'appui (7) dans la zone de leurs extrémités libres.

10. Dispositif selon l'une des revendications précédentes, en ce que sur l'autre face (U) de la barre de support (5) opposée à l'une des faces (O) sont montés des éléments élastomère (8), de préférence extrudés.

11. Dispositif selon la revendication 10, en ce que sur l'autre face (U) une rainure de fixation est prévue pour la fixation d'un ressort correspondant prévue sur l'élément élastomère (8).
